# EUROPÄISCHE PATENTSCHRIFT

(11) **EP 0 646 281 B1**
(45) Veröffentlichungstag und Bekanntmachung des Hinweises auf die Patenterteilung: **20.08.1997**
(21) Anmeldenummer: 93912573.8
(22) Anmeldetag: 08.06.1993
(51) Int. Cl.: H01H 37/76

(54) **THERMOSICHERUNG UND VERFAHREN ZU IHRER AKTIVIERUNG**
THERMAL PROTECTION DEVICE AND PROCESS FOR ACTIVATING THE SAME
DISPOSITIF DE PROTECTION THERMIQUE ET PROCEDE POUR SON ACTIVATION

(30) Priorität: 15.06.1992 DE 4219554
(43) Veröffentlichungstag der Anmeldung: 05.04.1995
(73) Patentinhaber: SIEMENS AKTIENGESELLSCHAFT, 80333 München (DE)
(72) Erfinder: KAUFMANN, August, D-81379 München (DE)
(86) Internationale Anmeldenummer: DE9300496
(87) Internationale Veröffentlichungsnummer: WO9326028

(56) Entgegenhaltungen:
- EP-A- 0 352 771
- GB-A- 2 077 500
- US-A- 4 135 176

## Beschreibung

Die Erfindung betrifft ein Verfahren zur Herstellung einer Thermosicherung zur Fixierung auf einem Schaltungssubstrat in Form eines Federbügels, der zwei Kontaktstellen, von denen mindestens eine eine Lötstelle ist, zur Verbindung mit entsprechenden Schaltungskontakten des Substrats sowie mindestens einen elastischen Federarm als Verbindungsabschnitt zwischen den beiden Kontaktstellen aufweist. (siehe DE-A- 3825897).

Derartige Sicherungen dienen zum Schutz von Schaltungsteilen vor thermischer Überlastung und können bei beliebigen Schaltungen, etwa auf Leiterplatten, eingesetzt werden. Bevorzugtes Anwendungsgebiet der erfindungsgemäßen Thermosicherung sind jedoch Schichtschaltungen.

Allgemein sind Thermosicherungen der eingangs genannten Art vielfach und für verschiedene Anwendungszwecke bekannt, z. B. aus der DE-B-15 15 624. Bei der dort gezeigten Sicherung wird der Federarm beim Einbau der Sicherung in seine Arbeitsposition vorgespannt. Er muß also durch eine besondere Vorrichtung während des Lötens und bis zum Erkalten der Lötverbindung in der Vorspannposition festgehalten werden. Dies erfordert besonders bei Schichtschaltungen eine komplizierte Handhabung und aufwendige Vorrichtungen.

Um das Einlöten unter Spannung zu vermeiden, wurde auch bereits vorgeschlagen (DE-A-38 25 897 und DE-A-39 30 819), die Federarme eines U-förmigen Sicherungsbügels mittels angeformter Stützelemente in ihrer vorgespannten Stellung abzustützen. Während des Einlötens sind somit keine Spann- oder Haltevorrichtungen erforderlich; die Abstützelemente müssen jedoch nach dem Löten entfernt oder freigebogen werden, um die Spannung der Federarme wirksam werden zu lassen.

Aufgabe der vorliegenden Erfindung ist es, eine noch einfachere Gestaltung einer Thermosicherung zu ermöglichen, bei der weder eine Vorspannhalterung beim Einlöten noch ein eigenes Abstützelement an den Federarmen selbst erforderlich ist.

Dies wird bei einer Thermosicherung dadurch erreicht, daß der Federbügel im Bereich zwischen den beiden Kontaktstellen einen plastisch deformierbaren Biegeabschnitt aufweist, daß der Abstand zwischen den beiden Kontaktstellen bei spannungsfreiem Federarm dem bestimmungsgemäßen Abstand der Schaltungskontakte des Substrats entspricht und daß durch Verformung des Biegeabschnittes eine Spannung im Federbügel erzeugbar ist, welche den Abstand zwischen den beiden Kontaktstellen zu verändern bestrebt ist. Das eingangs genannte Verfahren ist erfindungsgemäß dadurch gekennzeichnet, daß der Federbügel mit seinen Lötstellen spannungsfrei auf die Lötkontakte des Schaltungssubstrats gelegt und verlötet wird und daß dann durch Verformung eines Biegeabschnitts in dem Federbügel eine auf Veränderung des Abstandes zwischen den Lötstellen gerichtete Vorspannung erzeugt wird.

Bei der Erfindung wird also die Vorspannung des Federarms oder der Federarme erst nach dem Einlöten auf dem Schaltungssubstrat vorgenommen. Dadurch wird die Form des Federbügels besonders einfach und wirtschaftlich in der Herstellung sowie in der Handhabung beim Einlöten, da auch keine Abstützelemente angeformt und nachträglich entfernt werden müssen. Der Vorspannvorgang ist in einfacher Weise auf dem Schaltungssubstrat mit einfachen Biegestempeln durchführbar und erfordert nicht mehr Aufwand als beispielsweise die Entfernung der Abstützelemente bei der Thermosicherung gemäß DE-A-38 25 897.

Vorteilhafte Varianten des Verfahrens zur Herstellung einer Thermosicherung sind in den Unteransprüchen angegeben.

Die Erfindung wird nachfolgend an Ausführungsbeispielen anhand der Zeichnung näher erläutert. Es zeigen
Figur 1 eine Thermosicherung in zwei Ansichten,
Figur 3 die Form der Thermosicherung von Figur 2 in drei verschiedenen Phasen beim Gebrauch, nämlich nach dem Einlöten, nach ihrer Aktivierung und nach der Auslösung,
Figur 4 eine Thermosicherung gemäß Figur 2 ebenfalls in den drei Phasen wie in Figur 3, jedoch mit einer anderen Deformierung bei der Aktivierung.

Die in der Zeichnung dargestellte Thermosicherung besteht aus einem Federbügel 1, der aus einem Bandmaterial geschnitten und geformt ist. Er besitzt zwei Federarme 2 und 3, die über einen M-förmigen Biegeabschnitt 4 zusammenhängen. An den Enden der Federarme sind Lötstützen 5 und 6 angeformt, mit denen der Federbügel auf entsprechenden Lötkontakten einer Schaltung, vorzugsweise einer Schichtschaltung, verlötet werden kann. Um bei liegendem Einbau nicht durchgehend das Schaltungssubstrat zu berühren, besitzt der Federbügel außerdem zusätzliche Stützlappen 7 und 8. Somit wird bei Verwendung in der Schaltung ein Blitzüberschlag vermieden. Neben den Lötstützen sind außerdem Einkerbungen 9 vorgesehen, die ein Wegfließen des Lotes verhindern und damit eine hohe Lötqualität gewährleisten.

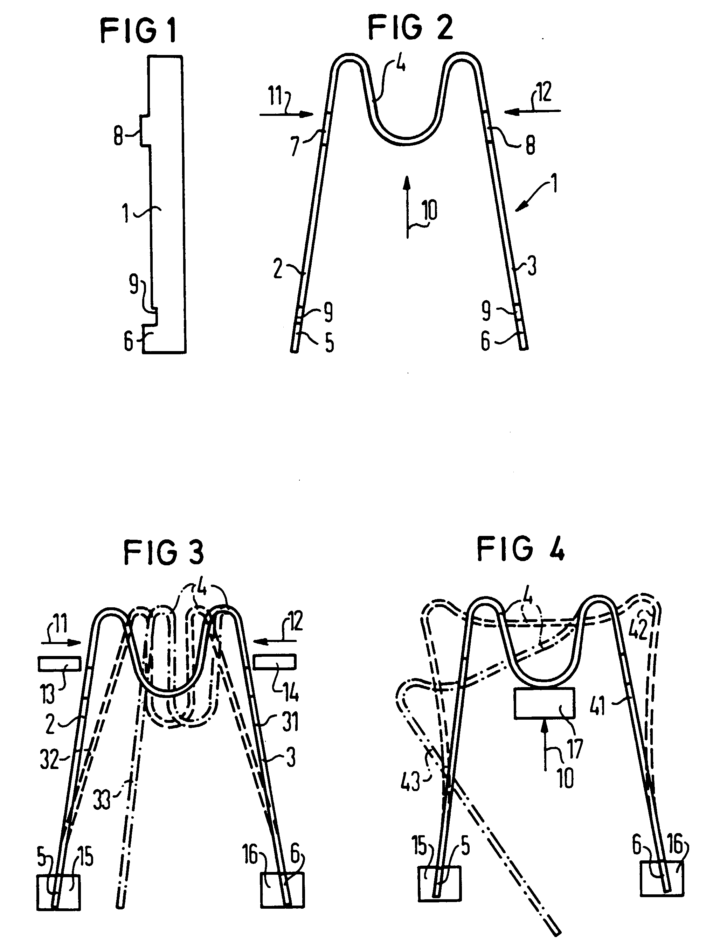

Die in Figur 2 dargestellte spannungsfreie Form des Federbügels wird bei der Herstellung bereits so gebogen, daß der Abstand zwischen den Lötstützen 5 und 6 ohne Vorspannung dem bestimmungsgemäßen Abstand der Lötkontakte auf dem Schaltungssubstrat entspricht, mit denen die Lötstützen der Thermosicherung verbunden werden sollen. Erst durch nachträglich Deformation, beispielsweise durch Krafteinwirkung annähernd parallel zu den Federschenkeln in Richtung des Pfeiles 10 oder quer zu den Federschenkeln in Richtung der Pfeile 11 und 12, wiro auf dem Schaltungssubstrat die benötigte Vorspannung erzeugt.

In Figur 3 ist die Form des Federbügels gemäß Figur 2 in verschiedenen Phasen des Einsatzes auf einer Schaltung gezeigt. In der ersten Phase, nämlich beim Einlöten auf dem Schaltungssubstrat, besitzt der Federbügel die Form wie in Figur 2. Sie ist in Figur 3 mit 31 bezeichnet und mit durchgehenden Linien darstellt. Dabei werden die Lötstützen 5 und 6 auf Lötkontakte 15 und 16 eines nicht weiter dargestellten Schaltungssubstrats gelegt und durch ein übliches Lötverfahren, beispielsweise durch Reflow-Löten kontaktiert. Anschließend wird von zwei Seiten mit Biegestempeln 13 und 14 auf den M-förmigen Biegeabschnitt 4 gedrückt, so daß der Federbügel insgesamt die gestrichelt gezeichnete Form 32 erhält. Der Biegeabschnitt 4 ist dabei plastisch deformiert, während die Federarme 2 und 3 eine Vorspannung erhalten.

Wird schließlich die Sicherung ausgelöst, indem das Lot auf dem Lötkontakt 15 schmilzt, löst sich der Federbügel an der betreffenden Seite von dem Schaltungssubstrat, dann nehmen die vorgespannten Federschenkel 2 und 3 ihre ursprüngliche Form ein, während der Biegeabschnitt 4 in der deformierten Gestalt verbleibt. Der Federbügel erhält somit insgesamt die strichpunktiert dargestellte Form 33.

Eine etwas abgewandelte Aktivierungsform ist in Figur 4 gezeigt. In diesem Fall wird der Biegeabschnitt 4 nach dem Einlöten auf den Lötkontakten 15 und 16 durch einen Biegestempel 17 in Richtung des Pfeiles 10 deformiert, so daß aus der Phase 41 mit der ursprünglichen Form nunmehr die Vorspannphase mit der Form 42 (gestrichelt gezeichnet) entsteht. Bei Auslösung der Sicherung entfernt sich die Lötstütze 5 von dem Lötkontakt 15. Es entsteht die strichpunktiert gezeigte Form 43.

Der Biegeabschnitt und die Federarme können beliebige Formen annehmen. Es ist jedoch wichtig, daß durch Deformation des Biegeabschnittes nach dem Einlöten eine Spannung in irgendeinem Teil des Federbügels entsteht, welche den Abstand zwischen den beiden Lötstützen zu verändern bestrebt ist.

## Patentansprüche

1. Verfahren zur Herstellung einer Thermosicherung zur Fixierung auf einem Schaltungssubstrat in Form eines Federbügels (1), der zwei Kontaktstellen (5, 6), von denen mindestens eine eine Lötstelle ist, zur Verbindung mit entsprechenden Schaltungskontakten des Substrats sowie mindestens einen elastischen Federarm (2, 3) als Verbindungsabschnitt zwischen den beiden Kontaktstellen (5, 6) aufweist,
**dadurch gekennzeichnet**,
daß der Federbügel (1) mit seinen Lötstellen (5, 6) spannungsfrei auf die Lötkontakte (15, 16) des Schaltungssubstrats gelegt und verlötet wird und daß dann durch Verformung eines Biegeabschnitts (4) in dem Federbügel (1) eine auf Veränderung des Abstandes zwischen den Lötstellen gerichtete Vorspannung erzeugt wird.

2. Verfahren nach Anspruch 1,
**dadurch gekennzeichnet**,
daß ein M-förmiger Biegeabschnitt (4) durch beiderseitige Krafteinwirkung quer zu den Federschenkeln (2, 3) deformiert wird (Figur 3).

3. Verfahren nach Anspruch 1,
**dadurch gekennzeichnet**,
daß ein M-förmiger Biegeabschnitt (4) durch Krafteinwirkung auf den Mittelteil annähernd parallel zu den Federschenkeln (2, 3) plastisch deformiert wird.

## Claims

1. Method for producing a thermal protection device for fixing on a circuit substrate in the form of a spring clip (1) which has two contact points (5, 6), at least one of which is a solder point, for connection to corresponding circuit contacts on the substrate, as well as at least one elastic spring arm (2, 3) as a connecting section between the two contact points (5, 6), characterized in that the spring clip (1) is located with its solder points (5, 6) in a stress-free manner on the solder contacts (15, 16) of the circuit substrate and is soldered, and in that a prestress, which is directed at a change in the distance between the solder points, is then produced by deforming a bent section (4) in the spring clip (1).

2. Method according to Claim 1, characterized in that an M-shaped bent section (4) is deformed by applying force on both sides transversely with respect to the spring limbs (2, 3) (Figure 3).

3. Method according to Claim 1, characterized in that an M-shaped bent section (4) is deformed plastically by applying force to the centre part approximately parallel to the spring limbs (2, 3).

## Revendications

1. Procédé de fabrication d'un dispositif de protection thermique destiné à être fixé sur un substrat de circuit et se présentant sous la forme d'un étrier de ressort (1) qui comprend deux points de contact (5, 6), dont au moins un est un joint à braser, en vue de la liaison avec des contacts de connexion correspondants du substrat, ainsi qu'au moins un bras de ressort élastique (2, 3) en tant que segment de liaison entre les deux points de contact (5, 6), caractérisé en ce que l'étrier de ressort (1) est posé et soudé, sans contrainte, avec ses joints à braser (5, 6), sur les contacts à braser (15, 16) du substrat de circuit, et en ce qu'une précontrainte visant à modifier la distance entre les joints à braser est produite ensuite dans l'étrier de ressort (1) par déformation d'un segment flexible (4).

2. Procédé selon la revendication 1, caractérisé en ce qu'un segment flexible (4) en forme de M est déformé de manière perpendiculaire aux branches de ressort (2, 3) sous l'action d'une force exercée sur les deux côtés.

3. Procédé selon la revendication 1, caractérisé en ce qu'un segment flexible (4) en forme de M subit une déformation plastique de manière à peu près parallèle aux branches de ressort (2, 3) sous l'action d'une force exercée sur la partie centrale.
